# EUROPEAN PATENT APPLICATION

(11) **EP 4 668 056 A1**
(43) Date of publication of application: **24.12.2025**
(21) Application number: 25183303.4
(22) Date of filing: 17.06.2025
(51) Int. Cl.: G06F 1/20, H01L 23/367, H01L 23/473, H05K 7/20

(54) **LIQUID-COOLED COMPUTING MODULE AND COMPUTING DEVICE**

(30) Priority: 18.06.2024 CN 202410787925
(71) Applicant: Bitdeer Semiconductor Technology PTE. LTD., 049514 Singapore (SG)
(72) Inventor: YANG, Senfeng, 049514 Singapore (SG); LI, Weiguo, 049514 Singapore (SG)
(74) Representative: Metida

(57) **Abstract**

Disclosed is a liquid-cooled computing module and a computing device. The liquid-cooled computing module includes a liquid cooling assembly and a hash board. At least two medium flow channels, connected by bends, are formed within the enclosure, and a plurality of heat dissipation fins are juxtaposed within each of the at least two medium flow channels. wherein at a bent connection of two communicated medium flow channels of the at least two medium flow channels, in the plurality of heat dissipation fins within one of the two communicated medium flow channels, some are contiguous fins and some are discontiguous fins, wherein the contiguous fins are arranged contiguously at least at the bent connection, and the discontiguous fins include straight plate portions and curved portions that are spaced apart, wherein the straight plate portions are parallel to a straight segment of the medium flow channel, the curved portions are disposed closer to the other of the two communicated medium flow channels than the straight plate portions, the curved portions are convex and smooth curved panel structures, and first ends of the curved portions away from the straight plate portions protrude beyond the contiguous fins. According to the present disclosure, the uniformity of the flow velocity and temperature of a medium flow in a width direction of the medium flow channel is increased, and the heat dissipation performance of the liquid cooling assembly is improved.

## Description

### TECHNICAL FIELD

The present disclosure relates to the technical field of liquid cooling, and in particular, relates to a liquid-cooled computing module and a computing device.

### BACKGROUND

With the advancement of technology, the demands on data processing capabilities of electronic devices, such as computing devices, are ever increasing, and heat dissipation challenges during operation of electronic devices have become particularly prominent. Some electronic devices employ liquid cooling solutions to enhance heat dissipation. However, in conventional liquid cooling assemblies (or heat exchangers or coolers), bubble generation is particularly severe at the bends (or turns) the medium flow channels, which adversely affects the overall heat dissipation performance of the liquid cooling assemblies. Specifically, there are discrepancies in heat dissipation performance across different positions in a width direction of the medium flow channels, resulting in poor temperature uniformity among chips disposed in the width direction. This often prevents computing devices from achieving an optimal performance. In some computing devices, wedge-shaped structures are arranged at the bends of the medium flow channels to guide the medium flow, as exemplified in a prior document CN113382618A. Although this solution reduces bubble generation to some extent, the stringent requirements for temperature uniformity across the various hash chips in the width of the medium flow channel still fail to be satisfied for ultra-high-performance computing (or supercomputing) devices.

### SUMMARY

In view of the above situation, the present disclosure is mainly intended to provide a liquid-cooled computing module and a computing device, which are capable of avoiding, as much as possible, generation of bubbles at bends of medium flow channels, and thus increasing the uniformity of the flow velocity and temperature of a medium flow in a width direction of the medium flow channels. In this way, the temperature uniformity of the chips at various positions is improved.

To achieve the above objective, the present disclosure employs the following technical solutions:

In a first aspect, embodiments of the present disclosure provide a liquid-cooled computing module. The liquid-cooled computing module includes a liquid cooling assembly and a hash board, wherein the hash board includes a substrate and a plurality of chips, the plurality of chips being arranged on a same surface of the substrate and are organized into a plurality of columns of chipsets, each of the chipsets including a plurality of chips arranged in series; wherein the liquid cooling assembly includes an enclosure and heat dissipation fins, wherein at least two medium flow channels, connected by bends, are formed within the enclosure, and a plurality of heat dissipation fins are juxtaposed within each of the at least two medium flow channels; wherein at a bent connection of two communicated medium flow channels of the at least two medium flow channels, in the plurality of heat dissipation fins within one of the two communicated medium flow channels, some are contiguous fins and some are discontiguous fins, wherein the contiguous fins are arranged contiguously at least at the bent connection, and the discontiguous fins include straight plate portions and curved portions that are spaced apart, wherein the straight plate portions are parallel to a straight segment of the medium flow channel, the curved portions are disposed closer to the other of the two communicated medium flow channels than the straight plate portions, the curved portions are convex and smooth curved panel structures, and first ends of the curved portions away from the straight plate portions protrude beyond the contiguous fins; and the hash board is mounted on an outer surface of the enclosure, and each of the chipsets is disposed in a region on the enclosure corresponding to the medium flow channels.

In some embodiments, among a plurality of discontiguous fins within a same medium flow channel, the curved portion of a discontiguous fin disposed on an outer side has a greater length than the curved portion of a discontiguous fin disposed on an inner side.

In some embodiments, among a plurality of discontiguous fins within a same medium flow channel, on a side close to the curved portions, end portions of the straight plate portions of the discontiguous fins are flush, or a straight plate portion disposed on an outer side protrudes beyond a straight plate portion disposed on an inner side.

In some embodiments, at a same bent connection, on a side of a plurality of contiguous fins of one of the medium flow channels close to another of the medium flow channels, a contiguous fin disposed on an outer side protrudes beyond a contiguous fin disposed on an inner side.

In some embodiments, among a plurality of heat dissipation fins within a same medium flow channel, the contiguous fins and the discontiguous fins are alternately arranged.

In some embodiments, at the bent connection, in the two communicated medium flow channels, some of the heat dissipation fins within each of the medium flow channels include the curved portions.

In some embodiments, at the bent connection of the two communicated medium flow channels, a curved portion of a discontiguous fin disposed on an upstream side is shorter than a curved portion of a discontiguous fin disposed on a downstream side.

In some embodiments, at a same bent connection, the plurality of heat dissipation fins of each of the medium flow channels are alternately arranged as the contiguous fins and the discontiguous fins sequentially from an outer side to an inner side; wherein for each of the contiguous fins of the medium flow channel disposed upstream, an end thereof close to the other medium flow channel is flush with a first end of a straight plate portion of an adjacent discontiguous fin disposed on an inner side; and in the medium flow channel disposed downstream, the contiguous fins protrude beyond a second end of a curved portion of an adjacent discontiguous fin thereof; wherein the first end of the straight plate portion is an end of the straight plate portion close to the curved portion, and the second end of the curved portion is an end of the curved portion close to the straight plate portion.

In some embodiments, a partition strip is arranged within the enclosure, wherein straight segments of the two communicated medium flow channels are juxtaposed and are separated by the partition strip, and the heat dissipation fins within each of the medium flow channels are respectively disposed on both sides of the partition strip.

In some embodiments, a flow guide pillar is disposed at the bent connection of the two communicated medium flow channels, wherein the flow guide pillar is disposed in an extension direction of the partition strip and is spaced apart between innermost curved portions of the two communicated medium flow channels.

In some embodiments, the curved portions are arc-shaped plates.

In some embodiments, among the at least two medium flow channels, an upstream end of a medium flow channel disposed furthest upstream is provided with a medium inlet, wherein a flow distributor is arranged between the medium inlet and the heat dissipation fins, the flow distributor having a first funnel-shaped structure, a smaller port of the first funnel-shaped structure being closer to the medium inlet than a larger port thereof.

In some embodiments, among the at least two medium flow channels, a downstream end of a medium flow channel disposed furthest downstream is provided with a medium outlet, wherein a flow collector is arranged between the medium outlet and the heat dissipation fins, the flow collector having a second funnel-shaped structure, a smaller port of the second funnel-shaped structure being closer to the medium outlet than a larger port thereof.

In some embodiments, a flow passage formed by each of the medium flow channels has a constant flow cross-sectional area at all positions.

In a second aspect, embodiments of the present disclosure provide a computing device. The computing device includes the liquid-cooled computing module as described above.

In the liquid-cooled computing module according to the present disclosure, a plurality of heat dissipation fins are juxtaposed within each of the medium flow channels of the liquid cooling assembly. At the bent of two communicated medium flow channels, some of the heat dissipation fins are configured as discontiguous fins that include curved portions. This allows the medium flow at the bent to be guided by the curved portions, thereby avoiding, as much as possible, severe impact of the medium flow against the sidewall of the medium flow channel at the bend connection (the severe impact could generate bubbles). Furthermore, by configuring the curved portion and the straight plate portion as a discontiguous structure (i.e., with a gap maintained between the curved portion and the straight plate portion), turbulence during the process of changing the flow direction along the curved portion is avoided, thereby further ensuring that substantially no bubbles are generated in the medium flow at the bend. Therefore, according to the present disclosure, the uniformity of the flow velocity and temperature of the medium flow across all positions in the width direction of the same medium flow channel is significantly improved. When the liquid cooling assembly is used to dissipate heat from a hash board, it is ensured that the temperatures of the chips disposed in the width direction of the medium flow channel are as consistent as possible. This enhances the temperature uniformity of the chips in the width direction, improves the operational performance of the entire hash board, and extends the service life of the entire supercomputing device.

Other beneficial effects of the present disclosure are described in retail with reference to specific technical features and technical solutions in the specific embodiments. A person skilled in the art may understand the beneficial effects achieved by these technical features and technical solutions through description of these technical features and technical solutions.

### BRIEF DESCRIPTION OF THE DRAWINGS

Some embodiments of the present disclosure are described with reference to accompanying drawings hereinafter.
FIG. 1 is a schematic structural view of a liquid cooling assembly in a liquid-cooled computing module according to some embodiments of the present disclosure;
FIG. 2 is a schematic exploded view of a liquid cooling assembly in a liquid-cooled computing module according to some embodiments of the present disclosure;
FIG. 3 is a schematic structural view of a base plate in a liquid cooling assembly in a liquid-cooled computing module according to some embodiments of the present disclosure;
FIG. 4 is a front view of the base plate illustrated in FIG. 3;
FIG. 5 is a partial structural front view of a base plate in a liquid cooling assembly in a liquid-cooled computing module according to some embodiments of the present disclosure;
FIG. 6 is a partial enlarged view of part I illustrated in FIG. 5;
FIG. 7 is a front view of a base plate in a liquid cooling assembly in a liquid-cooled computing module according to some embodiments of the present disclosure;
FIG. 8 is a schematic structural view of a computing device according to some embodiments of the present disclosure;
FIG. 9 is a schematic structural view of a computing device according to some embodiments of the present disclosure; and
FIG. 10 is a schematic structural view of a hash board in a computing device according to some embodiments of the present disclosure.

Reference numerals and denotations thereof: 10-liquid cooling assembly; 11-enclosure; 111-first flow channel; 112-second flow channel; 113-partition strip; 114-medium inlet; 115-medium outlet; 116-base plate; 1161-plate body; 1162-annular protrusion; 117-cover plate; 12-heat dissipation fin; 121-contiguous fin; 122-discontiguous fin; 1221-straight plate portion; 1222-curved portion; 13-flow guide pillar; 14-flow distributor; 15-flow collector; and 20-hash board; 21-substrate; 2-chip.

### DETAILED DESCRIPTION

The present disclosure is described with reference to some exemplary embodiments. However, the present disclosure is not limited to these exemplary embodiments. In the detailed description of the present disclosure, specific details are set forth. To avoid unnecessarily obscuring the substance of the present disclosure, well-known methods, procedures, processes, and components have not been described in detail.

Furthermore, it should be understood by persons of ordinary skill in the art that the drawings provided herein are for illustrative purposes only and are not necessarily drawn to scale.

Unless the context clearly requires otherwise, throughout this specification and the claims, the words "comprise," "contain," and the like are to be construed in an inclusive sense, as opposed to an exclusive or exhaustive sense, that is, in the sense of "including, but not limited to."

It should be noted that terms such as "first," "second," and the like are merely used for illustration purpose during the description of the present disclosure, and shall not be understood as indicating or implying relative importance. In addition, in the description of the present disclosure, the term "a plurality of," "more," or "a plurality of" refers to at least two unless otherwise specified.

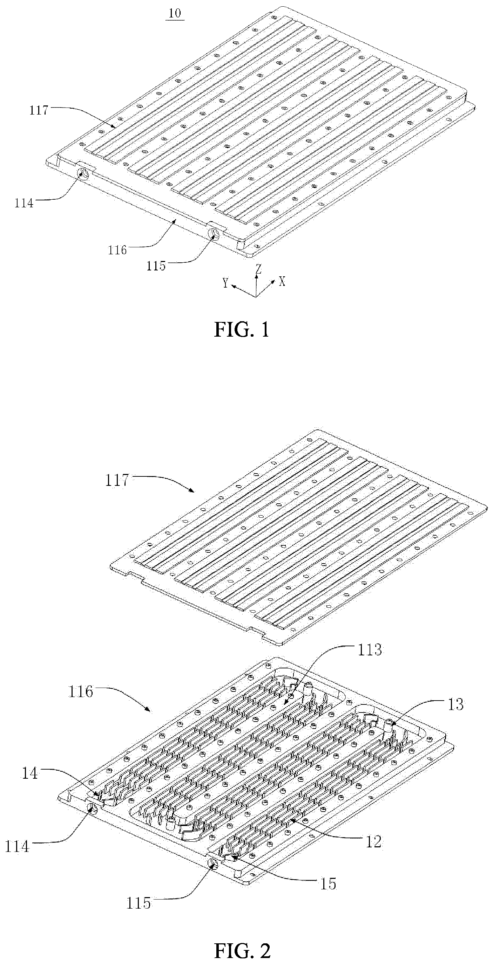

For convenience of description, a Cartesian coordinate system is established based on an extension direction X and a width direction Y of a medium flow channel, and a thickness direction Z of an enclosure in a liquid cooling assembly, as illustrated in FIG. 1. It should be noted that the establishment of this coordinate system is solely for convenience of description and does not impose specific limitations on the state of use of the liquid cooling assembly. During use or placement, the respective directions may be defined according to the actual orientation or operating state of a liquid cooling apparatus. As referred to herein, the terms "inner" and "outer" at a bent connection refer to radial inner and outer sides at the bent connection.

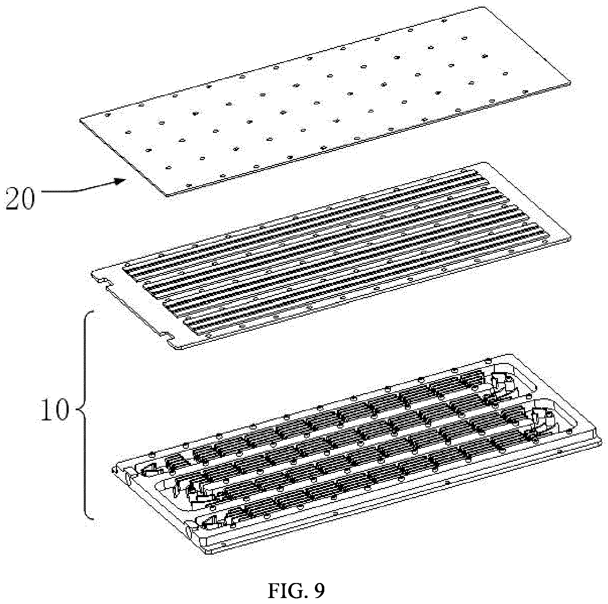

Some embodiments of the present disclosure provide a liquid-cooled computing module. The liquid-cooled computing module includes a liquid cooling assembly 10 and a hash board 20, as illustrated in FIG. 1 to FIG. 10. The hash board 20 includes a substrate 21 and a plurality of chips 22. The plurality of chips are arranged on a same side of the substrate 21 and are organized into a plurality of columns of chipsets, wherein each of the chipsets includes a plurality of chips 22 arranged in series. The liquid cooling assembly 10 is configured to dissipate heat from components on the hash board 20, and the hash board is mounted on an outer surface of the liquid cooling assembly 10.

Referring to FIG. 1 to FIG. 7, the liquid cooling assembly 10 includes an enclosure 11 and heat dissipation fins 12. At least two medium flow channels connected by bends (e.g., a first flow channel 111 and a second flow channel 112 each constitute one medium flow channel) are formed within the enclosure 11, and a plurality of heat dissipation fins 12 are juxtaposed within each of the medium flow channels. That is, only two medium flow channels may be arranged within the enclosure 11; or three, four, or more medium flow channels may be arranged. These medium flow channels are communicated to form a flow passage. Centerlines of the main segments (i.e., straight segments described hereinafter) of two communicated medium flow channels are not collinear. Specifically, the centerline of the main segment of each of the medium flow channels is substantially straight. That is, the main segment of each of the medium flow channels is a straight segment, and an extension direction X of the straight segment is a straight line. At a connection between one medium flow channel and another, the centerline may bend or curve. That is, each of the medium flow channels has both a curved segment and a straight segment. The two communicated medium flow channels are communicated at their bent connection via their respective curved segments. The centerlines of the main segments of the two communicated medium flow channels may be arranged at an angle to each other (e.g., the two centerlines are perpendicular or form an obtuse angle), or may be parallel to each other (e.g., the flow directions in the two medium flow channels are opposite), so as to change the direction of medium flow between two adjacent medium flow channels. Heat dissipation fins 12 are arranged within each of the medium flow channels. The heat dissipation fins 12 extend along an extension direction X of the medium flow channel, and a plurality of heat dissipation fins 12 are spaced apart in a width direction Y of the medium flow channel. For example, two, three, or more heat dissipation fins 12 are arranged in the width direction Y. These juxtaposed heat dissipation fins 12 are spaced apart from each other, thereby dividing the medium flow channel where the heat dissipation fins 12 are disposed into a plurality of medium sub-flow channels. When the hash board 20 is mounted on the liquid cooling assembly 10, the hash board 20 is disposed on an outer surface of the enclosure 11, and each of the chipsets is disposed in a region on the enclosure 11 corresponding to a medium flow channel.

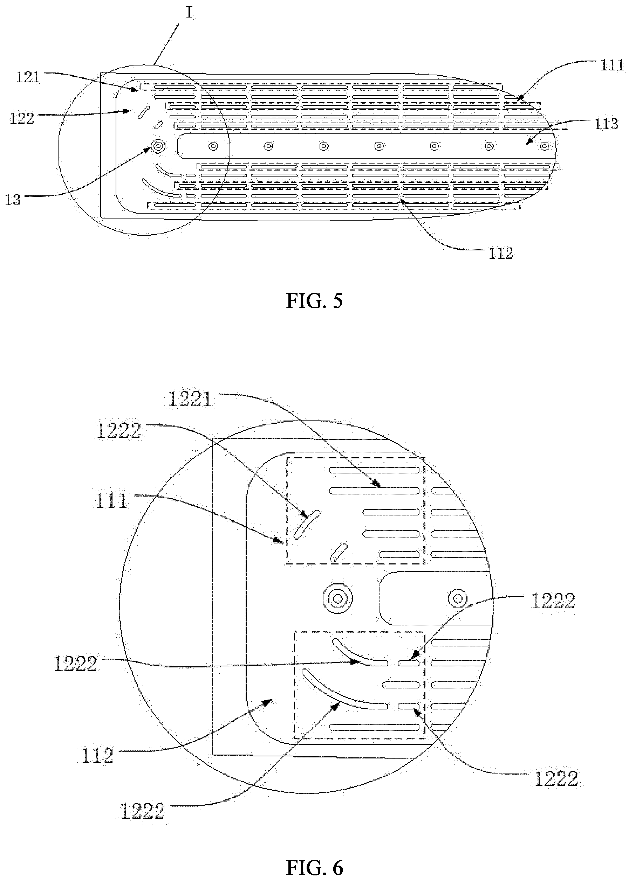

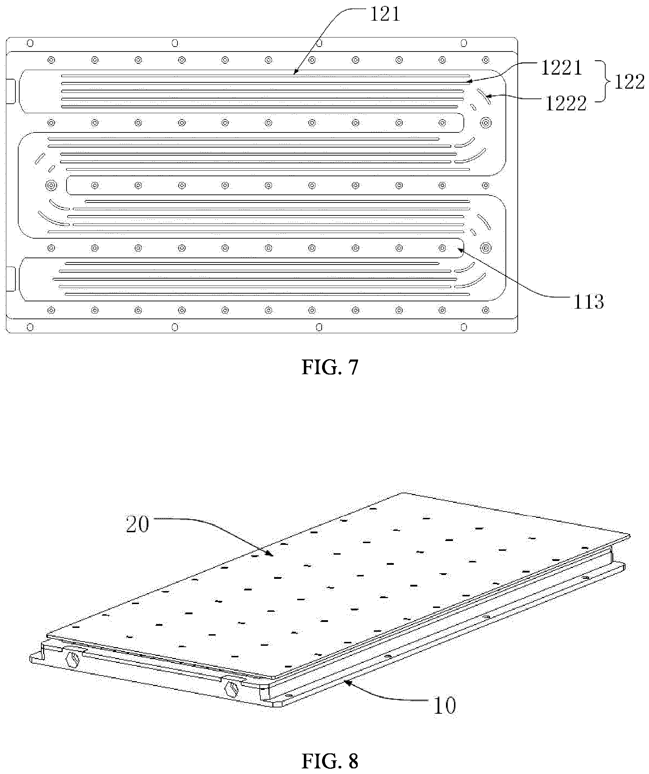

In the two communicated medium flow channels, at a bent connection thereof, among the plurality of heat dissipation fins 12 within one of the medium flow channels, some are contiguous fins 121, and some are discontiguous fins 122, as illustrated in FIG. 5. The heat dissipation fins 12 within the dashed box are contiguous fins 121, and the other fins are discontiguous fins 122. The contiguous fins 121 are contiguously arranged at least at the bent connection. The discontiguous fins 122 include straight plate portions 1221 and curved portions 1222 that are spaced apart. The straight plate portions 1221 are parallel to the straight segment of the medium flow channel. The curved portions 1222 are closer to the other medium flow channel than the straight plate portions 1221. The curved portion 1222 is a convex, smoothly curved plate structure, and a first end of the curved portion 1222, away from the straight plate portion 1221, extends beyond the contiguous fins 121. Still referring to FIG. 5 to FIG. 7, the two communicated medium flow channels may be respectively denoted as a first flow channel 111 and a second flow channel 112. The first flow channel 111 and the second flow channel 112 are bent and communicated. Among the plurality of heat dissipation fins 12 in the first flow channel 111, some heat dissipation fins 12 are contiguous fins 121, and some fins are discontiguous fins 122. The contiguous fins 121 may be contiguous plate-like structures throughout the entire first flow channel 111, as illustrated in FIG. 7; or may be contiguous plate-like structures only at the bent connection, and may be discontiguously arranged as a plurality of sub-segments in other parts, as illustrated in FIG. 5. Each of the discontiguous fin 122 extends in the extension direction X of the medium flow channel. At the bent connection, the straight plate portion 1221 and the curved portion 1222 of the discontiguous fin 122 are disconnected in the extension direction X of the first flow channel 111 and are spaced apart by a specific distance. The straight plate portion 1221 may be contiguously arranged in other parts of the first flow channel 111 (as illustrated in FIG. 7), or may be discontiguously arranged (as illustrated in FIG. 5). Regardless of which structure the straight plate portion 1221 adopts, the curved portion 1222 is a convex, smoothly curved plate structure. That is, each of the two opposing guide surfaces of the curved portion 1222 is a convex, smoothly curved surface, and both guide surfaces protrude towards an outer side of the medium flow channel, i.e., the guide surfaces protrude radially outwards at the bent connection, so as to smoothly guide the medium flow. The curved portion 1222 has a first end and a second end along an extension direction of the curved portion 1222. The first end is further from the straight plate portion 1221 than the second end. The second end is the end adjacent to the straight plate portion 1221. At the bent connection, the second end extends beyond the contiguous fins 121. That is, on the side of each of the heat dissipation fins 12 within the first flow channel 111 that is close to the second flow channel 112, the discontiguous fins 122 extend beyond the contiguous fins 121. The first end (i.e., the end of the contiguous fin 121 close to the second flow channel 112) of the discontiguous fin 122 is closer to the second flow channel 112 than the first end of the contiguous fin 121. It should be noted that, among the first flow channel 111 and the second flow channel 112, the first flow channel 111 may be upstream of the second flow channel 112, or the second flow channel 112 may be upstream of the first flow channel 111.

In the liquid cooling assembly 10, a plurality of heat dissipation fins 12 are juxtaposed within each of the medium flow channels. At the bent connection of two communicated medium flow channels, some of the heat dissipation fins 12 are configured as discontiguous fins that include curved portions 1222. This allows the medium flow at the bent connection to be guided by the curved portions 1222, thereby avoiding, as much as possible, severe impact of the medium flow against the sidewall of the medium flow channel at the bend connection (the severe impact could generate bubbles). Furthermore, by configuring the curved portion 1222 and the straight plate portion 1221 as a discontiguous structure (i.e., with a gap maintained between the curved portion 1222 and the straight plate portion 1221), turbulence during the process of changing flow direction along the curved portion 1222 may be avoided, thereby further ensuring that substantially no bubbles are are generated in the medium flow at the bend connection. Simultaneously, by extending the heat dissipation fins 12 to the bent connection of the medium flow channel, the medium flow may still be compressed to increase the velocity, substantially without reducing the flow area of the flow passage at the bent connection. Therefore, the liquid cooling assembly 10 according to the present disclosure significantly improves the uniformity of the flow velocity and temperature of the medium flow across all positions in the width direction Y of the same medium flow channel, while also increasing the flow velocity throughout the entire flow passage. When the liquid cooling assembly is used to dissipate heat from a hash board, it is ensured that the temperatures of the chips disposed in the width direction Y of the medium flow channel are as consistent as possible. This enhances the temperature uniformity of the chips in the width direction, improves the operational performance of the entire hash board, and extends the service life of the entire supercomputing device. In addition, in the liquid cooling assembly 10 according to the present disclosure, by configuration of the heat dissipation fins, especially the curved portions 1222 at the bent connections, the structural strength and anti-noise capabilities of the entire liquid cooling assembly 10 are also increased.

The respective straight segments of the plurality of medium flow channels may all be arranged in parallel, or some may be arranged in parallel while others form an angle therebetween. FIG. 2 to FIG. 7 illustrate embodiments where all straight segments are arranged in parallel, and also illustrate four medium flow channels. The flow area at the respective bent connections of each of the medium flow channels may be reduced. That is, the flow area at the bent connection within the same medium flow channel is smaller than the flow area of the straight segment. The flow areas of different medium flow channels may be equal or unequal. In some embodiments, the flow area of each of the medium flow channels is uniform throughout the length thereof, and the flow areas of different medium flow channels are also equal. That is, the flow area of the passage formed by the respective medium flow channels is equal at all positions, thereby enhancing the flow velocity throughout the entire flow passage.

The heat dissipation fins 12 are plate-like structures having a uniform wall thickness. The curved portion 1222 is also a structure having a uniform wall thickness. That is, the two guide surfaces of the curved portion 1222 are parallel. Specifically, the curved portion 1222 may be an arc-shaped plate, a parabolic plate, a free-form curved plate, or the like. When the curved portion 1222 is an arc-shaped plate, both guide surfaces are arc-shaped surfaces; when the curved portion 1222 is a parabolic plate, both guide surfaces are parabolic surfaces; and when the curved portion 1222 is a free-form curved plate, both guide surfaces are free-form curved surfaces. In some embodiments, the curved portion 1222 is an arc-shaped plate, which can be a circular arc plate or an elliptical arc plate, and is further preferably a circular arc plate. This may substantially prevent direct impingement of the medium flow against an inner wall of the medium flow channel, thereby enhancing the guide effect of the curved portion 1222 on the medium flow. The flow guide effect is particularly noticeable, especially when compared to a configuration that a wedge-shaped structure is arranged at the bent connection.

Within each of the medium flow channels, each of the heat dissipation fins may be a contiguously extending strip-like plate, and the curved portion 1222 disposed at an end of the strip-like plate. In some embodiments, each of the heat dissipation fins may include a plurality of sub-segments (i.e., including a plurality of sub-plates) arranged along a flow direction of the medium. The plurality of heat dissipation fins within each of the medium flow channels form a plurality of heat dissipation groups spaced apart in the direction of medium flow, wherein each of the heat dissipation groups includes a plurality of sub-segments from different heat dissipation fins. In the same curved segment of each of the medium flow channels, one heat dissipation group or a plurality of heat dissipation groups may be arranged. In the straight segment of each of the medium flow channels, one heat dissipation group or a plurality of heat dissipation groups may be provided. Preferably, the straight segment is longer relative to the curved segment. A plurality of heat dissipation groups are arranged in the straight segment, and one heat dissipation group is arranged in the same curved segment. Understandably, when at least three medium flow channels are communicated, some medium flow channels may each have two curved segments. The two curved segments are respectively disposed at both ends of a straight segment and are communicated respectively to a medium flow channel upstream of the medium flow channel and a medium flow channel downstream of the medium flow channel. In the straight segment of the medium flow channel, same-side ends of the sub-segments in each of the heat dissipation groups may be arranged flush. In the curved segment of the medium flow channel (i.e., in the segment at the bent connection), for a heat dissipation group arranged at the bent connection, the plurality of sub-segments may be flush at one end. That is, the ends at a second end of the straight plate portion 1221 are flush. The second end of the straight plate portion 1221 refers to an end of the straight plate portion 1221 away from the curved portion 1222.

A plurality of discontiguous fins 122 may be arranged at the bent connection of the same medium flow channel, and lengths of these discontiguous fins 122 may be equal or not equal. In some embodiments, among the plurality of discontiguous fins 122 within the same medium flow channel, the curved portion 1222 of a discontiguous fin 122 disposed on an outer side has a greater length than the curved portion 1222 of a discontiguous fin 122 disposed on an inner side. At the bent connection, the lengths of the curved portions 1222 may progressively decrease from the outer side towards the inner side. Alternatively, the lengths of any two or several adjacent curved portions 1222 can be equal, but shorter than the curved portion 1222 on their outer side and longer than the curved portion 1222 on the inner side. This enhances the flow guide effect on a radial outer side of the medium flow at the bent connection, such that the impingement with the medium flow channel wall is better avoided, and the flow distribution effect throughout the entire flow passage is further enhanced. It should be noted that the "length" mentioned above and hereinafter refers to a dimension in a bending direction of the curved portion 1222. The bending direction is also an extension direction of the discontiguous fin 122 at the curved portion 1222, and also a direction of medium flow at that position. When the curved portion 1222 is an arc-shaped plate, the plurality of curved portions 1222 within the same medium flow channel may be concentrically arranged.

Within the same medium flow channel, ends of the straight plate portions 1221 of the respective discontiguous fins 122, on a side close to the curved portion 1222, may be staggered (i.e., the ends are not aligned). In some embodiments, among the plurality of discontiguous fins 122 within the same medium flow channel, on a side close to the curved portion 1222, the ends of the straight plate portions 1221 of the discontiguous fins 122 are flush; or, a straight plate portion 1221 disposed on an outer side extends beyond a straight plate portion 1221 disposed on an inner side. As illustrated in FIG. 6, in the first flow channel 111, the ends of the straight plate portions 1221 close to the curved portion 1222 on the outer side extend beyond those on the inner side. In the second flow channel 112, the ends of the straight plate portions 1221 close to the curved portion 1222 are flush. Furthermore, within the same medium flow channel at the same bent connection, distances between the straight plate portion 1221 and the curved portion 1222 in different discontiguous fins 122 are substantially equal. This further contributes to a better flow distribution effect for the medium flow.

Still referring to FIG. 5 and FIG. 6, in two communicated flow channels, the first flow channel 111 and the second flow channel 112, among the plurality of heat dissipation fins within the same medium flow channel, the ends of the contiguous fins 121 at the bent connection, on the side close to the other communicated medium flow channel, may all be arranged flush, or only partially flush, or all non-flush. In some embodiments, at the same bent connection, on the side of a plurality of contiguous fins 121 of one medium flow channel that is close to the other medium flow channel, a contiguous fin disposed on the outer side extends beyond a contiguous fin disposed on the inner side. That is, in one medium flow channel at the same bent connection, in a case where the end of a contiguous fin 121 close to the other medium flow channel is denoted as a first end, then the first end of a contiguous fin 121 disposed on the outer side extends beyond the first end of a contiguous fin 121 disposed on the inner side. This reduces the portion of medium flow along an outer sidewall of the medium flow channel, such that a better guide effect is achieved for the medium flow at the bent connection, the uniformity of flow velocity and temperature of the medium flow in the width direction of the medium flow channel at the bent connection is increased, and the heat dissipation performance of the entire liquid cooling assembly is enhanced.

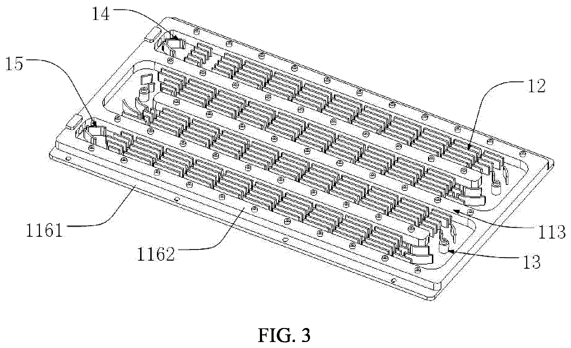

At the same bent connection of the same medium flow channel, the heat dissipation fins may be organized into inner and outer groups. The outer group of heat dissipation fins may all be discontiguous fins 122, and the inner group of heat dissipation fins may all be contiguous fins 121. Alternatively, the plurality of heat dissipation fins may be organized into a plurality of groups, with each group including one or more heat dissipation fins that are contiguous in the width direction Y of the medium flow channel (e.g., including one, two, or more heat dissipation fins). In two adjacent groups, the heat dissipation fins of one group are all contiguous fins 121, and the heat dissipation fins of the other group are all discontiguous fins 122. The group containing the contiguous fins 121 may be disposed at the outermost side in the width direction Y, or the group containing the discontiguous fins 122 can be disposed at the outermost side in the width direction Y. In some embodiments, a plurality of heat dissipation fins are alternately arranged as contiguous fins 121 and discontiguous fins 122, as illustrated in FIG. 3 to FIG. 7. Among the plurality of heat dissipation fins within the same medium flow channel, the contiguous fins 121 and the discontiguous fins 122 are arranged alternately. That is, in the width direction Y of the medium flow channel, among two adjacent heat dissipation fins, one is a contiguous fin 121, and the other is a discontiguous fin 122. Preferably, the outermost heat dissipation fin is a contiguous fin 121. This enhance the guide effect on the medium flow at all positions across the width direction of the medium flow channel at the bent connection, thereby improving the heat dissipation performance of the entire liquid cooling assembly.

In some embodiments, in two communicated medium flow channels, discontiguous fins 122 are arranged in only one of the medium flow channels at the bent connection of the two medium flow channels. Specifically, discontiguous fins 122 may be arranged only in an upstream medium flow channel, or only in a downstream medium flow channel. The embodiments are more suitable for cases where the straight segments of the two communicated medium flow channels form a non-zero angle (i.e., the two straight segments are not parallel), for example, when the two straight segments are perpendicular to each other. This reduces the manufacturing difficulty of the liquid cooling assembly. In the embodiments, it is preferable to arrange discontiguous fins 122 in the upstream medium flow channel.

In some other embodiments, in two communicated medium flow channels, at their bent connection, among the plurality of heat dissipation fins within each of the medium flow channels, some heat dissipation fins are discontiguous fins 122. That is, at the bent connection of the two communicated medium flow channels, both the upstream medium flow channel and the downstream medium flow channel are provided with curved portions 1222. This means that in the upstream medium flow channel, some heat dissipation fins at an downstream end include curved portions 1222; and in the downstream medium flow channel, some heat dissipation fins at an upstream end include curved portions 1222. In this manner, the medium flow is first guided towards the downstream side at the downstream end of the upstream medium flow channel, and then, through the curved portions 1222 of the downstream medium flow channel, the medium flow smoothly turns into the straight segment of the downstream medium flow channel, as illustrated in FIG. 6. Therefore, the embodiments may further reduce the impact of the medium flow against the flow channel sidewall, better enhance the guide effect on the medium flow at the bent connection, and keep the flow velocity and temperature of the medium flow in the width direction Y of the medium flow channel more uniform, thereby improving the heat dissipation effect of the entire liquid cooling assembly. Especially in embodiments where the straight segments of the two communicated medium flow channels are parallel to each other, simultaneously arranging the curved portions 1222 in both medium flow channels achieves a more prominent guide effect. When the liquid cooling assembly 10 is assembled with the hash board 20, temperature uniformity of the chips 22 at the bent connection is more significantly improved.

In embodiments where curved portions 1222 are simultaneously arranged at the bent connection of two communicated medium flow channels, the curved portion of a discontiguous fin on the upstream side is shorter than the curved portion of the discontiguous fin on the downstream side. In this way, the guide effect on the medium flow at the bent connection is further enhanced, and turbulence at the gap between each curved portion 1222 and the straight plate portion 1221 is reduced. This improves the uniformity of the flow velocity and temperature of the medium flow at various positions, thereby enhancing the heat dissipation performance, structural strength, and anti-noise capabilities of the entire liquid cooling assembly 10. When the curved portions 1222 are arc-shaped plates, a radius of curvature of the former (upstream curved portion) is greater than the arc curvature of the latter (downstream curved portion).

At the same bent connection, the plurality of heat dissipation fins of each of the medium flow channels are alternately arranged from the outer side to the inner side as contiguous fins 121 and discontiguous fins 122. As illustrated in FIG. 5 and FIG. 6, within the same medium flow channel, such as the first flow channel 111, the outermost heat dissipation fin is a contiguous fin 121, the adjacent inner heat dissipation fin is a discontiguous fin 122, the heat dissipation fin immediately inward of the discontiguous fin 122 is a contiguous fin 121, and the like. The contiguous fins 121 and the discontiguous fins 122 are alternately arranged, and the outermost heat dissipation fin is a contiguous fin 121. In the upstream medium flow channel, an end of each of the contiguous fins 121 close to the other medium flow channel is flush with a first end of the straight plate portion 1221 of a discontiguous fin 122 adjacently disposed on the inner side. In the downstream medium flow channel, the contiguous fin 121 extends beyond a second end of the curved portion 1222 of an adjacent discontiguous fin 122. The first end of the straight plate portion 1221 is an end of the straight plate portion 1221 close to the curved portion 1222, and the second end of the curved portion 1222 is an end thereof close to the straight plate portion 1221. Still referring to FIG. 6, assuming that in the two medium flow channels illustrated, the first flow channel 111 is disposed upstream, and the second flow channel 112 is disposed downstream (i.e., the medium flow is from the first flow channel 111 into the second flow channel 112), then an end of each of the contiguous fins 121 in the first flow channel 111 close to the second flow channel 112 is flush with a first end of a straight plate portion 1221 adjacently on an inner side of the contiguous fin 121. That is, in an upper flow channel, the contiguous fins 121 within each dashed box and the straight plate portions 1221 disposed on the inner side of the contiguous fins 121 are flush at their ends close to the second flow channel 112. In the second flow channel 112, each of the contiguous fins extends beyond a second end of a curved portion 1222. That is, when projected in the width direction, a projection of each of the curved portions 1222 and a projection of the contiguous fin 121 have an overlapping region. By adopting this arrangement, the guide effect on the entire medium flow at the bent connection may be further enhanced, such that the uniformity of temperature and flow velocity at various positions at that position is enhanced.

Furthermore, in the discontiguous fins 122 disposed in the upstream medium flow channel, the length of the curved portion 1222 is less than the length of the straight plate portion 1221. In the discontiguous fins 122 disposed in the downstream medium flow channel, the length of the curved portion 1222 is greater than the length of the straight plate portion 1221. With the heat dissipation fins, the flow path of the medium flow along a straight direction is extended as much as possible, thereby avoiding impacts on the flow velocity on the upstream side due to changes in the direction of medium flow. The longer curved portions 1222 on the downstream side enable the medium flow, when on the downstream side, to better turn into the straight segment of the downstream medium flow channel, such that the guide effect is enhanced, the flow velocity at the turn is increased, and the uniformity of medium flow temperature at all positions of the bent connection is increased.

Still referring to FIG. 5 and FIG. 6, at the same bent connection, the numbers of discontiguous fins 122 in the medium flow channels are equal, and the numbers of contiguous fins 121 are also equal. Furthermore, the intermittent fins 122 in each of the medium flow channels substantially divide the medium flow channel in which they are disposed into uniform sub-flow channels in the width direction. At the same bent connection, a plurality of curved portions 1222 in the upstream medium flow channel and a plurality of curved portions 1222 in the downstream medium flow channel are arranged in one-to-one correspondence. In a corresponding pair of curved portions 1222, a tangent plane at the downstream end of the upstream curved portion 1222 and a tangent plane at the upstream end of the downstream curved portion 1222 form an obtuse angle, or are even coplanar. That is, an included angle between the tangent plane at the downstream end of the curved portion 1222 on the upstream side and the tangent plane at the upstream end of the curved portion 1222 on the downstream side is from 90° to 180°, such as 90°, 120°, 135°, 150°, or 180°, etc. This further enhances the flow guide effect at the bent connection.

In some embodiments, a partition strip 113 is arranged within the enclosure 11. Straight segments of two communicated medium flow channels are juxtaposed. That is, the straight segments of the two medium flow channels are arranged in parallel and are separated by the partition strip 113. The heat dissipation fins 12 within each of the medium flow channels are arranged on two opposite sides of the partition strip 113. Referring to FIG. 3 to FIG. 7, an inner cavity of the enclosure 11 is divided by the partition strip 113 to form a plurality of sequentially bent and communicated medium flow channels. The medium flow channels are communicated to form a medium flow path. In an extension direction of the partition strip 113, one end of the partition strip 113 (i.e., a free end) is connected to a wall of the inner cavity, and the other end of the partition strip 113 is spaced apart from the wall of the inner cavity to allow medium flow. That is, two medium flow channels connected at the free end of the partition strip 113 are in communication with each other, that is, a bent connection is formed at that position. The respective heat dissipation fins (including the curved portions 1222) of two communicated medium flow channels are separated by this gap at the free end. That is, the heat dissipation fins of the two medium flow channels are not connected together. This further prevents the turbulence at the bent connection, increases the uniformity of the flow velocity and temperature of the medium flow in the width direction Y of the medium flow channel at this position, and enhances the heat dissipation performance of the entire liquid cooling assembly. Furthermore, the partition strip 113 also increases the structural strength and anti-noise capabilities of the entire liquid cooling assembly. Further, a positioning structure may also be arranged on the partition strip 113 to improve the assembly precision of a base plate 116 and a cover plate 117 (detailed hereinafter) of the enclosure 11, and especially to improve the assembly precision with the hash board 20 (detailed hereinafter).

In the gap space formed between the inner cavity wall of the enclosure 11 and the free end of the partition strip 113, no other structure may be arranged. In some embodiments, a guide pillar 13 is also arranged in this gap. That is, a guide pillar 13 is also arranged at the bent connection of two communicated medium flow channels. The guide pillar 13 is spaced apart from the partition strip 113 and the inner cavity wall of the enclosure 11. Specifically, the guide pillar 13 may be a cylinder, an elliptical cylinder, or other pillar with a smooth side surface, so as to further guide the medium flow via the guide pillar 13 when the medium flow passes through the gap space at the partition strip 113, enabling it to more smoothly enter the downstream medium flow channel.

Furthermore, the guide pillar 13 is disposed in an extension direction of the partition strip 113 and is spaced apart between the innermost curved portions 1222 of the two communicated medium flow channels, and the guide pillar 13 is spaced apart from these two innermost curved portions 1222 (i.e., not in contact), as illustrated in FIG. 5. The guide pillar 13 is disposed between the innermost curved portion 1222 of the first flow channel 111 and the innermost curved portion 1222 of the second flow channel 112. This better prevents impingement between the innermost part of the medium flow and an inner wall of the medium flow channel. Therefore, the uniformity of the flow velocity and temperature of the medium flow at this position is further enhanced.

Among the plurality of medium flow channels, a medium inlet 114 is arranged in an upstream end of the most upstream medium flow channel, and a medium outlet 115 is arranged in a downstream end of the most downstream medium flow channel. As illustrated in FIG. 1 and FIG. 2, a medium inlet 114 and a medium outlet 115 are respectively arranged in both ends of the flow passage formed by the plurality of medium flow channels.

In some embodiments, a flow distributor 14 is arranged between the medium inlet 114 and the heat dissipation fins. The flow distribution 14 has a first funnel-like structure, wherein a smaller port of the first funnel-like structure is closer to the medium inlet 114 than a larger port thereof. By adding the flow distributor 14 at the medium inlet 114, the medium flow, upon entering the flow passage, is uniformly distributed to all positions across the width direction Y of the medium flow channel. This further enhances the uniformity of the flow velocity and temperature of the medium flow at all positions in the width direction Y of the medium flow channel, and hence increases the heat dissipation performance of the entire liquid cooling assembly. Furthermore, the flow distributor 14 may also increase the structural strength and noise resistance capability of the entire liquid cooling assembly. Especially in embodiments where the flow distributor 14 is in contact and connected with both a plate body 1161 of the enclosure 11 and the cover plate 117 (detailed hereinafter), this performance is more prominent.

Further, a gap is maintained between the flow distributor 14 and the heat dissipation fins. That is, the flow distributor 14 is not in contact with any of the heat dissipation fins. When projected in the width direction Y of the medium flow channel, a distance is maintained between a projection of the flow distributor 14 and a projection of each of the respective heat dissipation fins in the medium flow channel where it is disposed; there is no overlapping region between the two projections. In this manner, while ensuring the uniformity of the flow velocity and temperature of the medium flow at all positions at the medium inlet 114, the turbulence at this position is also avoided, such that the uniformity of flow velocity and temperature of the medium flow in the width direction Y at this position is better improved.

Both ends of the larger port of the flow distributor 14 respectively face fin gap spaces, wherein a fin gap space refers to the space between two adjacent heat dissipation fins. Preferably, both ends of the larger port respectively face the innermost and outermost gap spaces in the width direction. In this manner, the medium flow more smoothly enters the sub-flow channels formed by the respective heat dissipation fins via the flow distributor 14, such that the uniformity of the flow velocity and temperature of the medium flow at all positions in the width direction Y of the medium flow channel is further enhanced.

In some embodiments, a flow collector 15 is arranged between the medium outlet 115 and the heat dissipation fins. The flow collector 15 has a second funnel-like structure, wherein a smaller port of the second funnel-like structure is closer to the medium outlet 115 than a larger port thereof. By adding the flow collector 15 at the medium outlet 115, the medium flow, after exiting the plurality of sub-flow channels formed by the heat dissipation fins, quickly converges into the medium outlet 115, while ensuring the uniformity of the flow velocity and temperature of the medium flow at all positions of the medium outlet 115. This enhances the heat dissipation performance of the entire liquid cooling assembly. Furthermore, the flow collector 15 may also increase the structural strength and noise resistance capability of the entire liquid cooling assembly. Especially in embodiments where the flow collector 15 is in contact and connected with both a plate body 1161 of the enclosure 11 and the cover plate 117 (detailed hereinafter), this performance is more prominent.

Further, a gap is maintained between the flow collector 15 and the heat dissipation fins. That is, the flow collector 15 is not in contact with any of the heat dissipation fins. When projected in the width direction Y of the medium flow channel, a distance is maintained between a projection of the flow collector 15 and a projection of each of the heat dissipation fins in the medium flow channel where the flow collector 15 is disposed, and there is no overlapping region between the two projections. In this manner, while ensuring the uniformity of the flow velocity and temperature of the medium flow at all positions at the medium outlet 115, the turbulence at this position is also avoided, such that the uniformity of flow velocity and temperature of the medium flow in the width direction Y at this position is better improved.

Both ends of the larger port of the flow collector 15 respectively face fin gap spaces, wherein a fin gap space refers to the space between two adjacent heat dissipation fins. Preferably, both ends of the larger port respectively face the innermost and outermost gap spaces in the width direction. In this manner, the medium flow more smoothly enters the sub-flow channels formed by the respective heat dissipation fins via the flow collector 15, such that the uniformity of the flow velocity and temperature of the medium flow at all positions in the width direction Y of the medium flow channel is further enhanced.

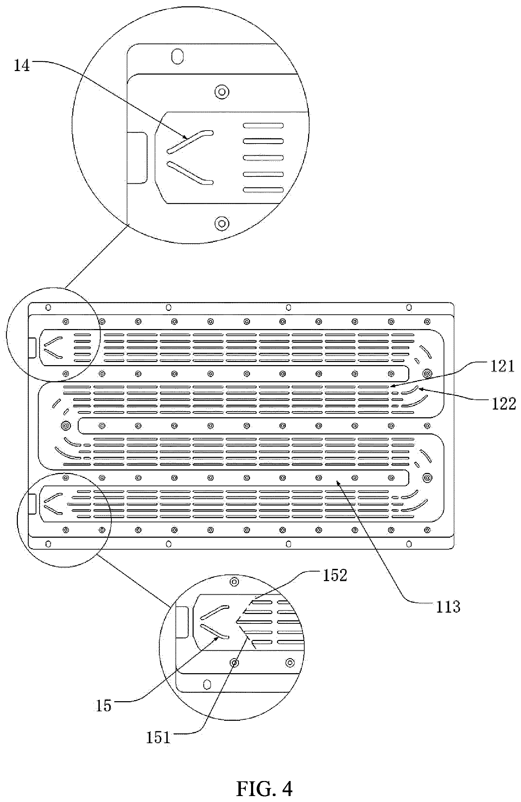

In some embodiments, in the medium flow channel where the flow collector 15 is arranged, ends of the respective heat dissipation fins 12 close to the flow collector 15 are non-aligned; instead, a connecting surface of the respective ends forms a bent surface. That is, ends of the respective heat dissipation fins 12 disposed on one side of a center plane in the width direction Y of the medium flow channel form a first surface 151, and ends of the respective heat dissipation fins disposed on the other side of the center plane form a second surface 152. The first surface 151 and the second surface 152 are arranged at a non-zero angle, as illustrated in FIG. 4, and their bent surfaces are convex towards the medium outlet 115. This ensures that, in the extension direction of the medium flow channel, the distances between the ends of the respective heat dissipation fins and the flow collector 15 are substantially equal, thereby further increasing the uniformity of flow velocity and temperature of the medium flow channel in the width direction.

Specifically, as illustrated in FIG. 2 and FIG. 3, the enclosure 11 has a substantially plate-like structure 61, and includes a base plate 116 and a cover plate 117. The base plate 116 includes a plate body 1161 and an annular protrusion 1162. The annular protrusion 1162 is protrudingly arranged on one side of the plate body 1161, such that the annular protrusion 1162 and the plate body 1161 enclose to define a recessed area. The partition strips 113 are disposed within the recessed area. A plurality of partition strips 113 may be arranged, and the specific number of partition strips 114 is determined by the number of medium flow channels to be formed. One end of each of the partition strips 113 is connected to the annular protrusion 1162, while the other end of the partition strip 113 forms a free end and is spaced apart from the annular protrusion 1162 to form the gap space to allow medium flow. The cover plate 117 covers the recessed area. The plate body 1161, the annular protrusion 1162, the partition strips 113, and the cover plate 117 collectively form a plurality of sequentially communicated medium flow channels. The heat dissipation fins may be arranged on the base plate 116 or on the cover plate 117. In some embodiments, the plate body 1161, the annular protrusion 1162, the partition strips 113, and the heat dissipation fins are integrally molded, and then connected to the cover plate 117, preferably by welding (e.g., brazing). After welding, the cover plate 117, the base plate 116, the partition strips 113, and the heat dissipation fins form an integral structure. Simultaneously, solder may fill the gaps between the cover plate 117 and these components. This ensures that the medium within the medium flow channels does not leak, while also increasing the structural strength of the entire liquid cooling assembly. In embodiments where a guide pillar 13 is arranged, the guide pillar 13 may also be integrally molded with the base plate 116, and the guide pillar 13 is in contact with both the plate body 1161 and the cover plate 117, thereby further increasing the structural strength of the entire liquid cooling assembly 10.

As illustrated in FIG. 8 to FIG. 10, the hash board 20 is mounted on an outer surface of the enclosure 11, and chips 22 are disposed in regions corresponding to the medium flow channels. Specifically, the hash board 20 is mounted on at least one outer surface of the enclosure 11 that faces away from the medium flow channels. That is, the hash board 20 is mounted on at least one outer surface of the enclosure 11 in a thickness direction Z of the enclosure 11. For example, the hash board 20 may be mounted only on a side of the cover plate 117 facing away from the base plate 116, or only on a side of the base plate 116 facing away from the cover plate 117. Alternatively, hash boards 20 may be mounted simultaneously on both these surfaces, which means that two hash boards 20 are mounted. The two hash boards 20 and the liquid cooling assembly 10 form a sandwich-like structure. In this manner, the liquid cooling assembly provides heat dissipation for the hash boards 20, thereby maintaining the temperature of the respective chips 22 on the hash board(s) 20 as uniform as possible and enhancing the operational performance of the entire hash boards 20.

Furthermore, each of the chips 22 is in contact with the enclosure 11 (including direct contact and indirect contact), and corresponds to a region on the enclosure 11 where a medium flow channel is arranged. That is, a medium flow channel and a chip 22 are respectively disposed on two sides of the enclosure wall in the thickness direction Z of the enclosure 11. In this manner, the heat conduction performance of the chips 22 to the medium flow is further enhanced.

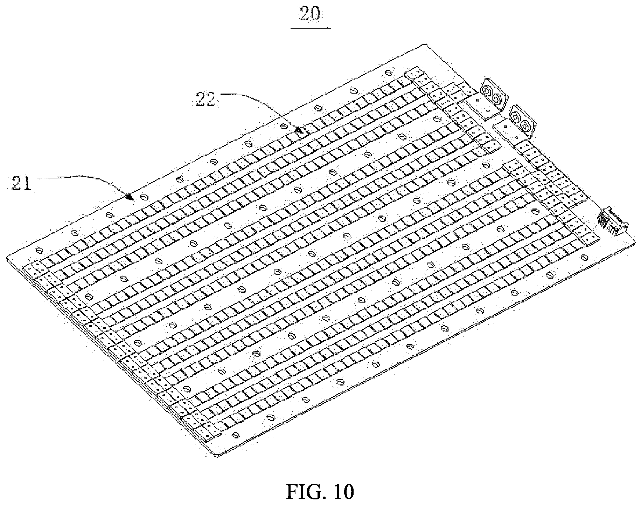

Referring to FIG. 10, a plurality of chips 22 are arranged as a plurality of columns of chipsets arrayed along the width direction Y, and each of the chipsets includes a plurality of chips 22 spaced apart along the extension direction X. Each column of chipsets is in contact with a region on the enclosure 11 where a medium flow channel is arranged. A region corresponding to one medium flow channel is in contact with a plurality of columns of chipsets. In this manner, each of the medium flow channels simultaneously conducts heat from a plurality of columns of chipsets, thereby enhancing heat dissipation efficiency while also ensuring that the temperature of these chipsets corresponding to the same medium flow channel is kept as uniform as possible in the width direction Y. Specifically, one medium flow channel can correspond to three groups of chipsets. At the bent connection of two communicated medium flow channels, two curved portions 1222 are arranged within the same medium flow channel, which divide the medium flow channel at that position into three sub-flow channels, preferably with uniform distribution. In this manner, each of the sub-flow channels corresponds to one group of chipsets, thereby better enhancing the heat dissipation performance of the liquid cooling assembly for the hash board 20 and ensuring temperature uniformity among the respective chips in the width direction of the same medium flow channel.

Understandably, the hash board 20 also includes signal lines, power lines, a signal terminal, and a power supply terminal. The signal lines and power lines may be arranged on the same side of the substrate 21 or on different sides of the substrate 21; for example, all power lines may be arranged on the side of the substrate 21 where the chips are arranged, while the signal lines are arranged on the other side of the substrate 21. The signal terminal and the power supply terminal may be arranged at an edge of the substrate 21 and are both electrically connected to the respective chips 22 for transmitting signals and supplying power to the respective chips 22.

For the assembly of the hash board 20 and the liquid cooling assembly 10, first mounting holes may be arranged in the enclosure 11, for example, at positions on the enclosure 11 corresponding to the annular protrusion 1162 and the partition strip 113. Second mounting holes corresponding to the first mounting holes are arranged in the hash board 20, specifically in the substrate 21. Subsequently, the assembly of the hash board 20 and the enclosure 11 is achieved through the engagement between fasteners and the first mounting holes and the second mounting holes. To ensure corresponding assembly of each column of chipsets with the medium flow channels, positioning pillars may be arranged on the annular protrusion 1162 and the partition strip 113, with first mounting holes arranged in these positioning pillars. Positioning holes corresponding to the positioning pillars are arranged in the cover plate 117. Second mounting holes corresponding to the first mounting holes are arranged in the hash board 20, specifically in the substrate 21. The cover plate 117 is fitted onto the base plate 116, and the corresponding positioning pillars and positioning holes are in positioning engagement. The hash board 20 is mounted on the enclosure 11 and secured to the enclosure 11 by fasteners in engagement with the corresponding first mounting holes and second mounting holes. The fasteners may be ordinary screws or spring screws.

Some embodiments of the present disclosure further provide a computing device for processing data, information, or the like. The computing device includes the liquid-cooled computing module according to any of the above-described embodiments. The computing device further includes a chassis, a power supply module, a control module, and the like. The liquid-cooled computing module, the power supply module, and the control module may all be mounted within the chassis. The power supply module and the control module are both electrically connected to the hash board 20. Specifically, the power supply module may be connected to a power supply terminal of the hash board 20, and the control module may be connected to a signal terminal of the hash board 20.

A person skilled in the art would understand that the above technical solutions may be freely combined and superimposed as long as no conflicts exist.

It should be understood that the above embodiments are only exemplary, and construe no limitations. Under the circumstance of not departing from the basic principles of the present disclosure, various obvious or equivalent modifications or substitutions that persons skilled in the art may derive to the above-described details are all included within the scope of the claims of the present disclosure.

## Claims

1. A liquid-cooled computing module, comprising: a liquid cooling assembly and a hash board, wherein the hash board comprises a substrate and a plurality of chips, the plurality of chips being arranged on a same surface of the substrate and are organized into a plurality of columns of chipsets, each of the chipsets comprising a plurality of chips arranged in series; wherein
the liquid cooling assembly comprises an enclosure and heat dissipation fins, wherein at least two medium flow channels, connected by bends, are formed within the enclosure, and a plurality of heat dissipation fins are juxtaposed within each of the at least two medium flow channels;
wherein at a bent connection of two communicated medium flow channels of the at least two medium flow channels, in the plurality of heat dissipation fins within one of the two communicated medium flow channels, some are contiguous fins and some are discontiguous fins, wherein the contiguous fins are arranged contiguously at least at the bent connection, and the discontiguous fins comprise straight plate portions and curved portions that are spaced apart, wherein the straight plate portions are parallel to a straight segment of the medium flow channel, the curved portions are disposed closer to the other of the two communicated medium flow channels than the straight plate portions, the curved portions are convex and smooth curved panel structures, and first ends of the curved portions away from the straight plate portions protrude beyond the contiguous fins; and
the hash board is mounted on an outer surface of the enclosure, and each of the chipsets is disposed in a region on the enclosure corresponding to the medium flow channels.

2. The liquid-cooled computing module according to claim 1, wherein among a plurality of discontiguous fins within a same medium flow channel, the curved portion of a discontiguous fin disposed on an outer side has a greater length than the curved portion of a discontiguous fin disposed on an inner side.

3. The liquid-cooled computing module according to claim 1, wherein among a plurality of discontiguous fins within a same medium flow channel, on a side close to the curved portions, end portions of the straight plate portions of the discontiguous fins are flush, or a straight plate portion disposed on an outer side protrudes beyond a straight plate portion disposed on an inner side.

4. The liquid-cooled computing module according to claim 1, wherein at a same bent connection, on a side of a plurality of contiguous fins of one of the medium flow channels close to another of the medium flow channels, a contiguous fin disposed on an outer side protrudes beyond a contiguous fin disposed on an inner side.

5. The liquid-cooled computing module according to claim 1, wherein among a plurality of heat dissipation fins within a same medium flow channel, the contiguous fins and the discontiguous fins are spaced apart.

6. The liquid-cooled computing module according to claim 1, wherein at the bent connection, in the two communicated medium flow channels, some of the heat dissipation fins within each of the medium flow channels comprise the curved portions.

7. The liquid-cooled computing module according to claim 6, wherein at the bent connection of the two communicated medium flow channels, a curved portion of a discontiguous fin disposed on an upstream side is shorter than a curved portion of a discontiguous fin disposed on a downstream side.

8. The liquid-cooled computing module according to claim 6, wherein at a same bent connection, the plurality of heat dissipation fins of each of the medium flow channels are alternately arranged as the contiguous fins and the discontiguous fins sequentially from an outer side to an inner side; wherein for each of the contiguous fins of the medium flow channel disposed upstream, an end thereof close to the other medium flow channel is flush with a first end of a straight plate portion of an adjacent discontiguous fin disposed on an inner side; and in the medium flow channel disposed downstream, the contiguous fins protrude beyond a second end of a curved portion of an adjacent discontiguous fin thereof;
wherein the first end of the straight plate portion is an end of the straight plate portion close to the curved portion, and the second end of the curved portion is an end of the curved portion close to the straight plate portion.

9. The liquid-cooled computing module according to claim 6, wherein a partition strip is arranged within the enclosure, wherein straight segments of the two communicated medium flow channels are juxtaposed and are separated by the partition strip, and the heat dissipation fins within each of the medium flow channels are respectively disposed on both sides of the partition strip.

10. The liquid-cooled computing module according to claim 9, wherein a flow guide pillar is disposed at the bent connection of the two communicated medium flow channels, wherein the flow guide pillar is disposed in an extension direction of the partition strip and is spaced apart between innermost curved portions of the two communicated medium flow channels.

11. The liquid-cooled computing module according to claim 1, wherein the curved portions are arc-shaped plates.

12. The liquid-cooled computing module according to any one of claims 1 to 11, wherein among the at least two medium flow channels, an upstream end of a medium flow channel disposed furthest upstream is provided with a medium inlet, wherein a flow distributor is arranged between the medium inlet and the heat dissipation fins, the flow distributor having a first funnel-shaped structure, a smaller port of the first funnel-shaped structure being closer to the medium inlet than a larger port thereof.

13. The liquid-cooled computing module according to any one of claims 1 to 11, wherein among the at least two medium flow channels, a downstream end of a medium flow channel disposed furthest downstream is provided with a medium outlet, wherein a flow collector is arranged between the medium outlet and the heat dissipation fins, the flow collector having a second funnel-shaped structure, a smaller port of the second funnel-shaped structure being closer to the medium outlet than a larger port thereof.

14. The liquid-cooled computing module according to any one of claims 1 to 11, wherein a flow passage formed by each of the medium flow channels has a constant flow cross-sectional area at all positions.

15. A computing device, comprising: the liquid-cooled computing module as defined in any one of claims 1 to 14.
